# EUROPEAN PATENT APPLICATION

(11) **EP 1 398 825 A2**
(43) Date of publication of application: **17.03.2004**
(21) Application number: 03020007.5
(22) Date of filing: 03.09.2003
(51) Int. Cl.: H01L 21/20, H01L 21/762

(54) **Substrate and manufacturing method therefor**

(30) Priority: 11.09.2002 JP 2002265782
(71) Applicant: CANON KABUSHIKI KAISHA, Ohta-ku, Tokyo (JP)
(72) Inventor:
(74) Representative: Leson, Thomas Johannes Alois, Dipl.-Ing.

(57) **Abstract**

This invention includes a step of forming the first substrate which has a semiconductor region and an insulating region on its surface and a step of coating the first substrate with a single-crystal semiconductor layer. In the coating step, a single-crystal semiconductor is longitudinally grown in the semiconductor region and then laterally grown to manufacture a substrate.

## Description

### FIELD OF THE INVENTION

The present invention relates to a substrate and manufacturing method therefor and, more particularly, to a substrate which has a partial insulating layer therein and a manufacturing method therefor.

### BACKGROUND OF THE INVENTION

Many research reports have been made on SOI structures as structures capable of increasing the speed of a device such as a CMOSFET or the like for use in a logic circuit and decreasing the power consumption. These SOI structures, however, are not necessarily suitable for forming, e.g., a DRAM, an analog IC, a power IC, and the like. For example, a DRAM is desirably formed not in a region (to be referred to as an "SOI region" hereinafter) insulated from a substrate by an insulating layer but in a bulk silicon region (to be referred to as a "non-SOI region" hereinafter) which is not insulated from the substrate, in order to reduce leakage currents and ensure data retention properties. In some cases, a non-SOI region is more preferable than an SOI-region to form an analog IC, a power IC, and the like.

Under the circumstances, a structure (to be referred to as a "partial SOI structure" hereinafter) combining an SOI region in which a single-crystal layer is formed on an insulating layer and a non-SOI region has been proposed. With this partial SOI structure, a logic circuit can be combined with a DRAM, an analog IC, or a power IC, thereby fabricating the circuitry needed for an electronic system on a single chip.

However, the application of a partial SOI structure in a micropatterning process may pose a problem such as degradation in exposure accuracy. For example, in a process for a CMOS transistor having a fine gate length, pattern exposure is performed using short-wavelength light, and the depth of focus is small. For this reason, if there is a height difference between an SOI region and a non-SOI region on a semiconductor substrate, the exposure accuracy degrades. More specifically, in a partial SOI structure of an SOI substrate, which is obtained by removing SOI and BOX layers to expose the substrate, there is a large height difference between an SOI region and a non-SOI region. Accordingly, this structure is not applied to a micropatterning process.

In Japanese Patent Laid-Open No. 11-17001, in an SOI structure formed on a semiconductor substrate, an SOI layer and buried insulating layer are partially removed, and a single-crystal layer is epitaxially grown onto the removed region, thereby eliminating a height difference between an SOI region and a non-SOI region. However, this method requires forming a film such as an insulating film or the like in the SOI region to prevent the single-crystal layer from epitaxially growing onto the SOI layer in the epitaxial growth step. With this method, if nonuniformity is created on the film due to a foreign substance or the like, single-crystal nuclei are formed on the SOI layer during the epitaxial growth step, and these single-crystal nuclei must be removed. Additionally, this method requires a step of forming a film before the epitaxial growth step and removing the film after the epitaxial growth step, thereby increasing the number of process steps.

Japanese Patent No. 2794702 discloses a method of forming an SOI substrate using a bonding method. This relates to a method of manufacturing a semiconductor having polysilicon directly under an insulating film of an SOI. This method, however, uses an original substrate as a portion on which a device is to be formed in a final substrate to be manufactured, and thus the thickness is extremely large. For this reason, this method cannot enjoy advantages of a general SOI substrate. In addition, a substrate to be processed by this method has a surface on which single-crystal and polycrystalline layers are combined. For this reason, the surface cannot sufficiently be planarized by mere polishing, and a bonded substrate obtained after bonding is low in strength.

### SUMMARY OF THE INVENTION

The present invention has been made in consideration of the above-mentioned problems, and has as its object to provide, e.g., a novel and useful substrate for manufacturing a substrate which has an insulating layer therein and a semiconductor layer on the insulating layer and a manufacturing method therefor.

According to the first aspect of the present invention, there is provided a substrate manufacturing method comprising a step of forming a first substrate which has a semiconductor region and an insulating region on a surface of the first substrate, and a step of coating the first substrate with a single-crystal semiconductor layer, wherein in the coating step, a single-crystal semiconductor is longitudinally grown in the semiconductor region and then laterally grown.

According to a preferred embodiment of the present invention, preferably, the step of forming the first substrate comprises a step of forming a separation layer therein the first substrate, and the method further comprises a step of bonding a second substrate to the first substrate coated with the single-crystal semiconductor layer to form a bonded substrate, and a step of splitting the bonded substrate at the separation layer.

According to a preferred embodiment of the present invention, the method preferably further comprises a step of planarizing the single-crystal semiconductor layer on the first substrate before the step of forming the bonded substrate.

According to the second aspect of the present invention, there is provided a substrate that can be manufactured by the above manufacturing methods.

According to the third aspect of the present invention, there is provided a substrate comprising a first single-crystal semiconductor layer bonded to the substrate, a partial insulating layer buried in the first single-crystal semiconductor layer, and a second semiconductor layer arranged on the first single-crystal semiconductor layer and partial insulating layer.

According to a preferred embodiment of the present invention, the first single-crystal semiconductor layer is preferably formed by epitaxially growing the first single-crystal semiconductor layer on the second semiconductor layer.

According to a preferred embodiment of the present invention, the first single-crystal semiconductor layer is preferably different from the second semiconductor layer in crystal orientation in at least one of a crystal face and an in-plane orientation.

According to a preferred embodiment of the present invention, a crystal defect is preferably introduced between the first single-crystal semiconductor layer and the substrate.

According to a preferred embodiment of the present invention, the first single-crystal semiconductor layer preferably has a crystal defect in the vicinity of the insulating layer.

According to a preferred embodiment of the present invention, the substrate preferably includes a single-crystal semiconductor selected from the group consisting of Si, Ge, SiGe, SiC, C, GaAs, AlGaAs, InGaAs, InP and InAs.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

The accompanying drawings, which are incorporated in and constitute a part of the specification, illustrate embodiments of the invention and, together with the description, serve to explain the principles of the invention.
Fig. 1A is a view for explaining a substrate manufacturing method according to the preferred embodiment of the present invention;
Fig. 1B is a view for explaining the substrate manufacturing method according to the preferred embodiment of the present invention;
Fig. 1C is a view for explaining the substrate manufacturing method according to the preferred embodiment of the present invention;
Fig. 1D is a view for explaining the substrate manufacturing method according to the preferred embodiment of the present invention;
Fig. 1E is a view for explaining the substrate manufacturing method according to the preferred embodiment of the present invention;
Fig. 1F is a view for explaining the substrate manufacturing method according to the preferred embodiment of the present invention;
Fig. 1G is a view for explaining the substrate manufacturing method according to the preferred embodiment of the present invention;
Fig. 1H is a view for explaining the substrate manufacturing method according to the preferred embodiment of the present invention;
Fig. 1I is a view for explaining the substrate manufacturing method according to the preferred embodiment of the present invention;
Fig. 1J is a view for explaining the substrate manufacturing method according to the preferred embodiment of the present invention;
Fig. 2 is a view for explaining the substrate manufacturing method according to the preferred embodiment of the present invention;
Fig. 3 is a view for explaining the substrate manufacturing method according to the preferred embodiment of the present invention;
Fig. 4 is a view for explaining the substrate manufacturing method according to the preferred embodiment of the present invention; and
Figs. 5A to 5C are views for explaining the substrate manufacturing method according to the preferred embodiment of the present invention.

### DETAILED DESCRIPTION OF THE PREFERRED EMBODIMENT

A preferred embodiment of the present invention will be described below with reference to the accompanying drawings.

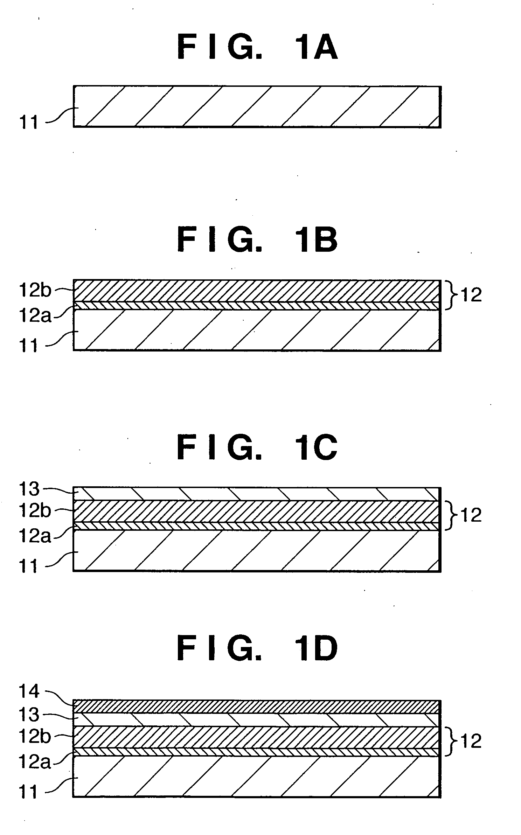

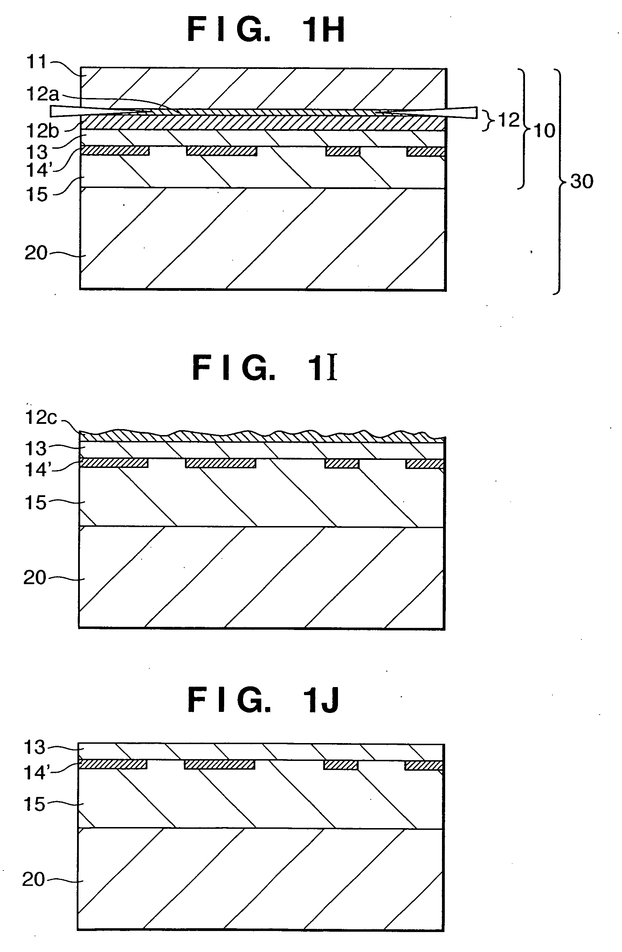

Figs. 1A to 1J are views for explaining a substrate manufacturing method according to a preferred embodiment of the present invention. In the step shown in Fig. 1A, a substrate (seed substrate) 11 is prepared, and in the step shown in Fig. 1B, a separation layer 12 is formed on the substrate (seed substrate) 11. The substrate 11 includes a single-crystal semiconductor of one of Ge, SiGe, SiC, C, GaAs, AlGaAs, InGaAs, InP, InAs, and the like in addition to single-crystal silicon. As the separation layer 12, e.g., a porous layer formed by anodizing the surface of the single-crystal Si substrate 11 is preferably employed. This anodization can be performed by placing an anode and cathode in an electrolyte solution containing hydrofluoric acid, placing the single-crystal Si substrate 11 between the electrodes, and applying a current between them. The porous layer may comprise two or more layers with different porosities. A porous layer having a multilayered structure is formed by, e.g., changing the current density of a current to be applied to the single-crystal Si substrate 11. More specifically, after a separation layer (porous layer) 12b is formed as the first layer on the surface of the Si substrate 11 at a low current density, the current density is increased. Then, a separation layer (porous layer) 12a can be formed as the second layer below the resultant layer. Note that in this embodiment the separation layer 12 includes a layer in which ions of hydrogen, He, or the like are implanted or a layer formed by stacking single-crystal layers with different lattice constants, in addition to a single porous Si layer or multiple porous Si layers.

In the step shown in Fig. 1C, a single-crystal Si layer 13 is formed on the separation layer 12 by epitaxial growth. Epitaxial growth provides a formation of single-crystal Si layer 13 of good quality.

In the step shown in Fig. 1D, an oxide film 14 serving as an insulating layer is formed on the single-crystal Si layer 13. Although the oxide film 14 can be formed by, e.g., thermal oxidation, the present invention is not limited to this. Plasma oxidation, liquid phase growth, chemical vapor deposition (CVD), or the like may be used instead. Generally, an oxide film of good quality can be formed by thermal oxidation. An insulting layer may be formed using any other insulating material such as a nitride film, instead of the oxide film 14.

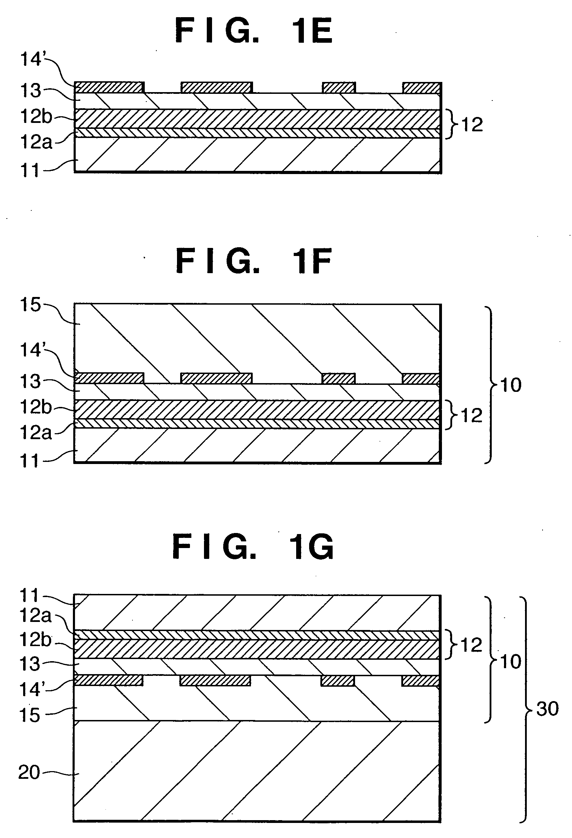

In the step shown in Fig. 1E, after the oxide film 14 is coated with a resist, it is patterned by lithography to form an opening. Part of the oxide film 14 which is exposed at the bottom of the opening is etched by dry etching such as reactive ion etching (RIE) or wet etching using, e.g., a chemical solution. With this operation, a partial oxide film 14' is formed on the single-crystal Si layer 13. A partial oxide film is defined as an oxide film which is formed such that the single-crystal Si layer 13 is at least partially exposed.

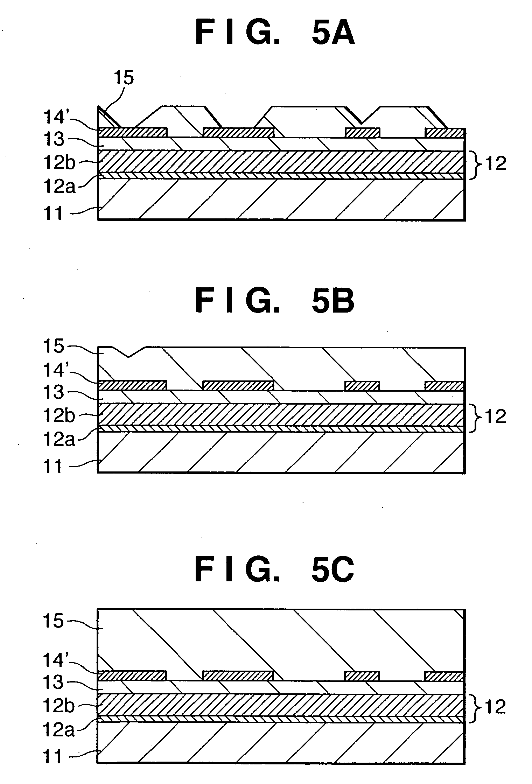

In the step shown in Fig. 1F, a single-crystal Si layer (single-crystal semiconductor layer) 15 is selectively grown on an exposed portion (semiconductor region) of the single-crystal Si layer 13 in the partial oxide film 14' (insulating region) to cover the partial oxide film 14' on the single-crystal Si substrate 11. Figs. 5A to 5C are views schematically showing how the single-crystal Si layer 15 grows. The single-crystal Si layer 15 (see Fig. 5C), which covers the entire surface of the substrate, can be formed by epitaxially and longitudinally growing single-crystal silicon on an exposed portion of the single-crystal Si layer 13 (see Fig. 5A) and epitaxially and laterally growing the single-crystal silicon (Fig. 5B).

Longitudinal epitaxial growth of single-crystal silicon means epitaxially and mainly longitudinally growing the single-crystal Si layer as a whole. Similarly, lateral epitaxial growth of single-crystal silicon means epitaxially and mainly laterally growing the single-crystal Si layer as a whole. The relationship between the growth rate of lateral epitaxial growth and that of longitudinal epitaxial growth is not particularly specified, and it is important that the growth rate of lateral epitaxial growth is at least not 0. It is also important to inhibit formation of a nucleus on the oxide film in longitudinal epitaxial growth.

To selectively and epitaxially grow single-crystal silicon only on single-crystal silicon, e.g., CVD, sputtering, LPE, solid phase growth, or the like may be used. In CVD, preferably, the substrate is prebaked at 1, 000°C for 3 min , and then SiH₂Cl_{z} gas , HCl gas, and H₂ gas are supplied at flow rates of 0.53 liters/min, 1.2 liters/min, and 180 liters/min or 0.2 liters/min, 0.4 liters/min, and 22 liters/min, respectively, at 900°C at 80 Torr. This embodiment is not limited to these conditions. The above-mentioned addition of HCl can inhibit the formation of an Si nucleus on the partial oxide film 14' and can selectively and epitaxially grow single-crystal silicon on the exposed single-crystal Si layer 13. If silicon is epitaxially grown under these conditions, single-crystal silicon, having epitaxially and longitudinally grown on the single-crystal Si layer 13, can laterally grow onto the partial oxide film 14' to cover the partial oxide film 14'. To cover the partial oxide film 14', preferably, the partial oxide film 14' has a small region and is set such that the single-crystal Si layer 15 can easily cover the partial oxide film 14'. For example, the partial oxide film 14' can be set to have a width equivalent to that of an SOI transistor. However, the present invention is not limited to this, and the any width may be set as far as the single-crystal Si layer 15 can easily cover the partial oxide film 14'.

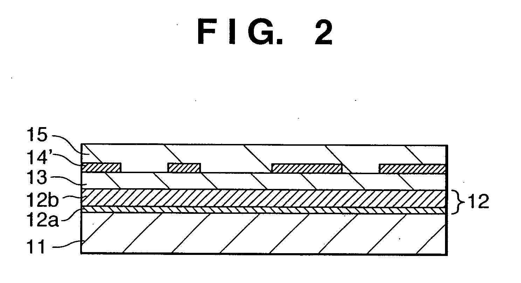

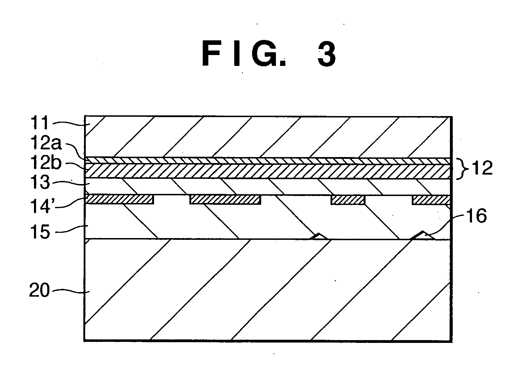

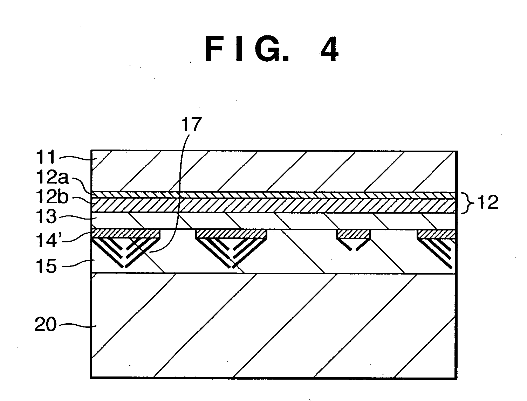

After the single-crystal Si layer 15 is grown in the above-mentioned manner, the surface of the single-crystal Si layer 15 may be ground and polished so as to be flat (see Fig. 2). In this case, the separation layer 12 need not be formed in advance. The selective growth of the single-crystal Si layer 15 may be completed in a state wherein the surface of the single-crystal Si layer 15 is not flat, and an unbonded portion 16 may be formed immediately under the partial oxide film 14' in a bonding step (to be described later), as shown in Fig. 3. Then, a gettering site for metal contamination as a crystal defect may be formed between the single-crystal Si layer 15 and a second substrate 20 (to be described later). In addition, a defect 17 may be introduced into a lateral epitaxial layer on the partial oxide film 14' in the selective growth of the single-crystal Si layer 15, as shown in Fig. 4, and the defect 17 may be used as the gettering site for metal contamination.

In the step shown in Fig. 1G, the second substrate (handle substrate) 20 is bonded to the surface (a surface in which the single-crystal Si layer 15 is exposed) of a first substrate 10 shown in Fig. 1F to form a bonded substrate 30. As the second substrate 20, a single-crystal Si substrate or a substrate obtained by forming an insulating film (e.g., an oxide film) on a single-crystal Si substrate can typically be used. However, any other substrate such as an insulating substrate (e.g., a glass substrate) may be adopted as the second substrate 20. Although a substrate having a structure shown in Fig. 1G is referred to as the first substrate for the sake of convenience, a substrate having a structure shown in any one of Figs. 1A to 1F may also be referred to as the first substrate.

In the step shown in Fig. 1H, the bonded substrate 30 is split into two substrates by splitting the bonded substrate 30 at the separation layer 12. The bonded substrate 30 is typically split by separating the separation layer (porous layer) 12a as the first layer from the separation layer (porous layer) 12b as the second layer. This splitting may be performed by, e.g., using a fluid. As a method of using a fluid, a method of forming a fluid (liquid or gas) jet and injecting it to the separation layer 12, a method of utilizing the static pressure of a fluid, or the like is preferably used. Among these methods, a method of utilizing water as a fluid is referred to as a water jet method. The above-mentioned splitting can also be performed by, e.g., annealing the bonded substrate 30. Such splitting by annealing is particularly effective in forming an ion implantation layer as the separation layer 12. Additionally, the splitting can be performed by, e.g., inserting a member such as a solid wedge into the separation layer 12.

In addition to the above-mentioned splitting methods, a grinding and polishing method in which the back surface (exposed surface) of the bonded substrate 30 is ground and polished to leave a single-crystal Si layer with a predetermined thickness on the insulating film 14' may be adopted. In this case, the separation layer 12 need not be formed in advance.

In the step shown in Fig. 1I, a separation layer 12c left on the single-crystal Si layer 13 is removed using an etchant or the like. At this time, the single-crystal Si layer 13 can be used as an etching stopper layer. Then, the surface of the substrate may be planarized by performing a planarizing step such as a hydrogen annealing step, polishing step, or the like, as needed.

In this manner, as shown in Fig. 1J, a substrate comprising the single-crystal Si layer 15, partial oxide film 14' buried in the single-crystal Si layer 15, the single-crystal Si layer 13 arranged on the single-crystal Si layer 15 and partial oxide film 14' can be manufactured.

As described above, the preferred embodiment of the present invention can form a partial SOI structure in which the upper surfaces of an SOI region (insulating region) and non-SOI region (semiconductor region) are flat. Accordingly, no height difference (nonuniformity or the like) is created between the SOI and non-SOI regions, and a surface to be exposed can be prevented from deviating from the depth of focus in, e.g., micropatterning using short-wavelength light.

By forming an unbonded portion immediately under the insulating film in bonding, a gettering site for metal contamination can be formed. If a defect is introduced to a lateral epitaxial layer on the insulating film, the defect can be used as a gettering site for metal contamination. If the surface of a grown selective epitaxial layer is planarized, bonding can be performed without polishing. Since the surface of the substrate is coated with single crystals, the microroughness of the surface can be suppressed, and the bonding strength between the substrate and a substrate to be bonded becomes high.

### [Examples]

Preferred examples of the present invention will be described below.

### (Example 1)

First, a first single-crystal Si substrate 11 of p-type or n-type having a resistivity of 0.01 to 0.02 Ω · cm was prepared (this corresponds to the step shown in Fig. 1A).

Then, the single-crystal Si substrate 11 was anodized in an anodizing solution, thereby forming a porous Si layer serving as a separation layer 12. The anodizing conditions were as follows.
Current density: 7 (mA · cm⁻²)
Anodizing solution: HF : H₂O : C₂H₅OH = 1 : 1 : 1
Time: 11 (min)
Thickness of porous silicon: 12 (µm)

The current density and the concentrations of the respective components of the anodizing solution can appropriately be changed in accordance with the thickness, structure, and the like of the separation layer (porous Si layer) 12 to be formed. Preferably, the current density falls within the range of 0 to 700 mA/cm², and the ratio between the concentrations of the above components of the anodizing solution falls within the range of 1 : 10 : 10 to 1 : 0 : 0.

The porous Si layer is useful because a high-quality epitaxial Si layer is formed thereon and the porous Si layer functions as a separation layer. If the first and second substrates are bonded together to form a bonded substrate, and then the bonded substrate is ground to remove part of the first substrate, the porous Si layer need not be used as a separation layer.

The anodizing solution only needs to contain HF and need not contain ethanol. Ethanol, however, is useful for removing any air bubbles from the surface of the substrate and is preferably added to the anodizing solution. Examples of a chemical agent which has a function of removing air bubbles include, e.g., alcohols such as methyl alcohol and isopropyl alcohol, a surfactant, and the like in addition to ethanol. Instead of adding these chemical agents, air bubbles may be eliminated from the substrate surface by vibrations of ultrasonic waves or the like.

The thickness of the porous Si layer is not limited to the above example. Satisfactory results can be obtained as far as the thickness falls within the range of, e.g., several hundred µm to 0.1 µm.

The anodized substrate was oxidized in an oxygen atmosphere at 400°C for 1 hr. With this oxidizing step, the inner walls of pores of the porous Si layer were covered with a thermally oxidized film.

A single-crystal Si layer 13 having a thickness of 0.3 µm is epitaxially grown on the porous Si layer by chemical vapor deposition (CVD) (this corresponds to the step shown in Fig. 1C). The growth conditions were as follows.
Source gas: SiH₂Cl₂/H₂
Gas flow rate: 0.5/180 L/min
Gas pressure: 80 Torr
Temperature: 950°C
Growth rate: 0.3 µm/min

Note that these growth conditions can appropriately be changed in accordance with required specifications of the single-crystal Si layer 13.

Prior to the epitaxial growth step, the substrate may be baked in an epitaxial reactor in a hydrogen atmosphere, and/or a minimum amount of silicon source may be supplied to the substrate in the epitaxial reactor. Then, the pores in the surface of the porous Si layer may be filled to planarize the substrate. By performing such an additional step, an epitaxial layer having a minimum defect density (10⁴ cm⁻² or less) could be formed on the porous Si layer.

An oxide film 14 having a thickness of 200 nm was formed on the epitaxial Si layer 13 by thermal oxidation (this corresponds to the step shown in Fig. 1D).

A mask material (preferably, SiN or the like) was deposited on the oxide film, and a resist was further applied to its surface. These materials were sequentially patterned such that an opening was formed in a non-SOI region (or a thick-SOI region in which a thick Si layer is formed on an insulating film). Since this example uses a bonding method (e.g., ELTRAN: a registered trademark) in which the first substrate and second substrate are bonded together, patterning must be so performed as to form a mirror image of a normal pattern.

If a mask material is not deposited on the oxide film 14, a resist is applied to the oxide film 14 and is patterned to form a resist pattern. Then, the oxide film 14 is etched through an opening of the resist pattern to expose the epitaxial Si layer 13.

On the other hand, if a mask material is deposited on the oxide film 14, a resist is applied to the mask material and is patterned to form a resist pattern. Then, the mask material is etched through an opening of the resist pattern, thereby performing patterning for the mask material. The oxide film 14 is etched through an opening of the mask material until the epitaxial Si layer 13 is exposed, thereby performing patterning for the oxide film 14. At this time, the resist may be removed after the patterning of the mask material and before the patterning of the oxide film 14.

When the resist and mask material were removed, a substrate in which the epitaxial Si layer 13 was partially exposed was obtained.

By performing the epitaxial growth step again, a single-crystal semiconductor layer 15 was longitudinally grown on an exposed portion of the epitaxial Si layer 13 and then laterally grown to cover a partial oxide film 14' serving as an insulating layer (this corresponding to the step shown in Fig. 1F). To form the single-crystal semiconductor layer 15 by CVD, preferably, the substrate is prebaked at 1,000°C for 3 min, and then SiH₂Cl₂ gas , HCl gas , and H₂ gas are supplied at flow rates of 0.53 liters/min, 1.2 liters/min, and 180 liters/min or 0.2 liters/min, 0.4 liters/min, and 22 liters/min, respectively, at 900°C at 80 Torr. The present invention is not limited to these conditions. The above-mentioned addition of HCl can inhibit the formation of an Si nucleus on the partial oxide film 14' and can selectively and epitaxially grow single-crystal silicon on the exposed epitaxial Si layer 13. If silicon is epitaxially grown under these conditions, single-crystal silicon laterally grows onto the partial oxide film 14' to cover the partial oxide film 14'. To cover the partial oxide film 14', the partial oxide film 14' preferably has a small region. For example, desirably, the partial oxide film 14' has a width equivalent to that of an SOI transistor and is set such that the single-crystal semiconductor layer 15 can easily cover the partial oxide film 14'. The thickness of the single-crystal semiconductor layer 15 can appropriately be determined in accordance with specifications required by a final semiconductor substrate. For example, the thickness can be set to 10 µm.

The surface of a first substrate 10 and that of a second Si substrate 20 separately prepared were overlaid on and brought into contact with each other. After that, the both substrates were subjected to annealing in a nitrogen atmosphere or oxygen atmosphere at 1,100°C for 1 hr to increase the bonding strength between the first substrate 10 and the second substrate 20 (this corresponds to the step shown in Fig. 1G). With this operation, a bonded substrate 30 was obtained. Prior to the substrate overlaying step, the thickness of the second semiconductor layer 15 can be reduced by polishing the surface of the substrate. As the polishing step, CMP may be performed. To remove any portion damaged by polishing in the polishing step, a cleaning step and/or etching step may further be performed.

Pure water was injected from a 0.1-mm nozzle of a water jet apparatus toward a concave portion (concave portion formed by the beveled portions of the two substrates 10 and 20) of the periphery of the bonded substrate 30 in a direction parallel to the bonding interface of the bonded substrate 30 at a high pressure of 500 kgf/cm². With this operation, the bonded substrate 30 was splitted at the separation layer 12 into two substrates (this corresponds to the step shown in Fig. 1H). The pressure of the pure water preferably falls within the range of several ten kgf/cm² to 1,000 kgf/cm².

In this splitting step, any one of the following operations may be performed.
(1) The nozzle performs scanning such that a jet of pure water injected from the nozzle moves along the concave portion formed by the beveled portions.
(2) The bonded substrate 30 is held by a wafer holder and rotates on its axis to inject pure water into the concave portion formed by the beveled portions around the periphery of the bonded substrate.
(3) The operations (1) and (2) are performed in combination.

Consequently, the partial oxide film 14, the epitaxial Si layers 13 and 15, and a part 12c of the porous Si layer 12, which were originally formed on the side of the first substrate 10 were moved to the side of the second substrate 20. Only a porous Si layer 12a was left on the surface of the first substrate 11.

Instead of splitting the bonded substrate by a water jet method, a jet of gas may be used or a solid wedge may be inserted into the separation layer of the bonded substrate. Alternatively, a mechanical force such as a tensile force, shearing force, or the like may be applied to the bonded substrate or ultrasonic waves may be applied to the bonded substrate. In addition, any other method may be adopted.

Moreover, out of the two substrates constituting the bonded substrate, a portion from the back surface of the first base 10 to the porous Si layer may be removed by grinding, polishing, etching, or the like without splitting the bonded substrate, thereby exposing the entire surface of the porous silicon layer.

At this time, any one of the following operations may be performed.
(1) A portion from the exposed surface of the first substrate of the bonded substrate to the porous Si layer is continuously ground.
(2) A portion from the exposed surface of the first substrate of the bonded substrate is continuously ground until just before reaching the porous Si layer, and the remaining bulk silicon is removed by dry etching such as RIE or wet etching.
(3) A portion from the exposed surface of the first substrate of the bonded substrate is continuously ground until just before reaching the porous Si layer, and the remaining bulk silicon is removed by polishing.

The porous Si layer 12c which was moved to the uppermost surface of the second substrate 20 was selectively etched using an etchant in which at least a 49% hydrofluoric acid solution, a 30% hydrogen peroxide solution, and water were mixed (this corresponds to the step shown in Fig. 1J). The single-crystal Si layer 13 was left unetched. The porous Si layer 12c was selectively etched using the single-crystal Si layer 13 as an etch stopper and completely removed. If selective etching is performed while starting/stopping generating ultrasonic waves using an apparatus combined with a circulator and rotating a wafer, non-uniform etching in the surface and among substrates can be suppressed. Additionally, if alcohol or a surfactant is mixed with the etchant, nonuniformity in etching caused by gaseous reaction products on the surface can be suppressed.

The etching speed of a non-porous single-crystal Si layer with the etchant is extremely low, and the selectivity ratio to the etching speed of a porous layer reaches 10⁵ or more. The etching amount (about several ten A) in a non-porous layer reduces the film thickness by a substantially negligible amount.

With the above-mentioned steps, a semiconductor substrate which had the single-crystal Si layer 13 with a thickness of 0.2 µm on the partial oxide film 14' and single-crystal Si layer 15 in the partial oxide film 14' was obtained. Although the porous Si layer 12c was selectively etched, no change occurred in the single-crystal Si layer 13. When the film thickness of the formed single-crystal Si layer 13 was measured at 100 points across the surface, the uniformity of the film thickness was 201 nm ± 4 nm.

The observation of the cross section with a transmission electron microscope showed that the single-crystal Si layer 13 had no additional crystal defects and maintained good crystallinity.

Furthermore, the substrate was subjected to annealing (hydrogen annealing) in a hydrogen atmosphere at 1,100°C for 1 hr, and the surface roughness was evaluated with an atomic force microscope. The root-mean-square roughness in a 50-µm-square region was about 0.2 nm, which was equivalent to that of a commercially available silicon wafer.

The surface may be planarized by polishing such as CMP, instead of hydrogen annealing.

If plasma processing is performed for at least one of respective surfaces to be bonded of the first and second substrates as a preprocess of the bonding step, the bonding strength can be increased even by annealing at a low temperature. Additionally, a substrate having undergone plasma processing is preferablyrinsed by pure water.

In the splitting step, a plurality of bonded substrates may be arranged in their crystal face, and a nozzle of a water jet apparatus may perform scanning along the crystal face, thereby continually splitting the plurality of bonded substrates.

Alternatively, a plurality of bonded substrates may be arranged in a direction perpendicular to each plane, and a nozzle of a water jet apparatus may be provided with an X-Y scanning function. Then, a jet of water may sequentially be injected toward a plurality of bonding portions, and the bonded substrates may automatically and continually be split.

The single-crystal Si layer 13 and single-crystal Si layer 15 may be made of, e.g., SiGe, GaAs, SiC, C, or the like, instead of silicon (Si).

As the second substrate 20, a substrate made of, e.g., quartz, sapphire, ceramic, carbon, SiC, or the like may be adopted, in addition to an Si substrate.

### (Example 2)

This example is an improved example of the example 1 and is the same as the example 1 except for anodizing conditions.

In this example, a single-crystal Si substrate 11 was prepared and anodized in a solution containing HF under either of the following anodizing conditions (this corresponds to the step shown in Fig. 1B).

### (First Anodizing Condition)

### (First Step)

Current density: 8 (mA · cm⁻²)
Anodizing solution: HF : H₂O : C₂H₅OH = 1 : 1 : 1
Time: 11 (min)
Thickness of porous silicon: 13 (µm)

### (Second Step)

Current density: 22 (mA · cm⁻²)
Anodizing solution: HF : H₂O : C₂H₅OH = 1 : 1 : 1
Time: 2 (min)
Thickness of porous silicon: 3 (µm)
or

### (Second Anodizing Condition)

### (First Step)

Current density: 8 (mA · cm⁻²)
Anodizing solution: HF: H₂O: C₂H₅OH = 1 : 1 : 1
Time: 5 (min)
Thickness of porous silicon: 6 (µm)

### (Second Step)

Current density: 33 (mA ·cm⁻²)
Anodizing solution: HF : H₂O: C₂H₅OH = 1 : 1 : 1
Time: 1.3 (min)
Thickness of porous silicon: 3 (µm)

A first porous Si layer 12b to be formed at the first step of the anodization is used to form a high-quality epitaxial Si layer thereon. A second porous Si layer 12a to be formed under the first porous Si layer 12b at the second step of the anodization is used as a separation layer. Note that if the first substrate is removed by grinding a bonded substrate, a porous Si layer is not used as a separation layer.

The position of a separation surface (a surface to be separated) was limited to the vicinity of the interface between the first porous Si layer 12b and second porous Si layer 12a. This was effective in planarization of the separation surface.

### (Example 3)

A DRAM having a trench capacitor was formed in the non-SOI region of a semiconductor substrate which was manufactured by each of the methods described in the examples 1 and 2 and had a structure shown in Fig. 1J. Other devices including a logic circuit were formed in the SOI region. Since the methods described in the examples 1 and 2 are bonding methods, the surface of a semiconductor substrate to be manufactured is flat. For this reason, in the lithography step, the entire region of exposure shots fell within the focus-range of the depth of a projection optical system, and no local defocusing (defocusing due to nonuniformity of the surface of the substrate) occurred. Since a single-crystal Si layer having a sufficient thickness was formed in the non-SOI region, no trouble occurred in forming the trench capacitor.

The above semiconductor substrate is effectively used to form an integrated circuit other than a DRAM-embedded one.

### (Other Example)

Various film forming techniques such as CVD, MBE, sputtering, liquid phase growth can be applied to the epitaxial growth step for forming a single-crystal semiconductor layer.

Also, various other etchants (e.g., a mixture of a hydrofluoric acid solution, nitric acid solution, and acetic acid solution) can be applied to the step of selectively etching a separation layer (porous layer, ion implantation layer, or the like) left upon splitting, in addition to a mixture of a 49% hydrofluoric acid solution, a 30% hydrogen peroxide solution, and water as described above.

According to the present invention, there can be provided a novel and useful substrate for manufacturing a substrate which has an insulating layer therein and a semiconductor layer on the insulating layer and a manufacturing method therefor.

As many apparently widely different embodiments of the present invention can be made without departing from the spirit and scope thereof, it is to be understood that the invention is not limited to the specific embodiments thereof except as defined in the claims.

This invention includes a step of forming the first substrate which has a semiconductor region and an insulating region on its surface and a step of coating the first substrate with a single-crystal semiconductor layer. In the coating step, a single-crystal semiconductor is longitudinally grown in the semiconductor region and then laterally grown to manufacture a substrate.

## Claims

1. A substrate manufacturing method comprising:
a step of forming a first substrate, the first substrate having a semiconductor region and an insulating region on a surface thereof; and
a step of coating the first substrate with a single-crystal semiconductor layer,
wherein in the coating step, a single-crystal semiconductor is longitudinally grown in the semiconductor region and then laterally grown.

2. The method according to claim 1, wherein
the step of forming the first substrate comprises a step of forming a separation layer in the first substrate, and
the method further comprises
a step of bonding a second substrate to the first substrate coated with the single-crystal semiconductor layer to form a bonded substrate, and
a step of splitting the bonded substrate at the separation layer.

3. The method according to claim 2, further comprising a step of planarizing the single-crystal semiconductor layer on the first substrate before the step of forming the bonded substrate.

4. A substrate manufactured by a substrate manufacturing method as defined in claim 1.

5. A substrate comprising:
a first single-crystal semiconductor layer bonded to the substrate;
a partial insulating layer buried in said first single-crystal semiconductor layer; and
a second semiconductor layer arranged on said first single-crystal semiconductor layer and said partial insulating layer.

6. The substrate according to claim 5, wherein said first single-crystal semiconductor layer is formed by epitaxially growing the first single-crystal semiconductor layer on said second semiconductor layer.

7. The substrate according to claim 6, wherein said first single-crystal semiconductor layer is different from said second semiconductor layer in crystal orientation in at least one of a crystal face and an crystal face orientation.

8. The substrate according to claim 7, wherein a crystal defect is introduced between said first single-crystal semiconductor layer and the substrate.

9. The substrate according to claim 5, wherein said first single-crystal semiconductor layer has a crystal defect in the vicinity of said insulating layer.

10. The substrate according to claim 5, wherein the substrate includes a single-crystal semiconductor selected from the group consisting of Si, Ge, SiGe, SiC, C, GaAs, AlGaAs, InGaAs, InP and InAs.
